# EUROPEAN PATENT SPECIFICATION

(11) **EP 4 375 688 B1**
(45) Date of publication and mention of the grant of the patent: **31.12.2025**
(21) Application number: 22904522.4
(22) Date of filing: 21.11.2022
(51) Int. Cl.: G01R 31/389, G01R 31/392, G01R 31/396, G01R 31/367, G01N 27/02, H01M 10/42, H01M 10/44, H01M 10/48

(54) **METHOD AND APPARATUS FOR DIAGNOSING BATTERY CELL**
VERFAHREN UND VORRICHTUNG ZUR DIAGNOSE EINER BATTERIEZELLE
PROCÉDÉ ET APPAREIL POUR DIAGNOSTIC D'ÉLÉMENT DE BATTERIE

(30) Priority: 08.12.2021 KR 20210174607
(43) Date of publication of application: 29.05.2024
(73) Proprietor: LG ENERGY SOLUTION, LTD., Seoul 07335 (KR)
(72) Inventor: JEON, Chulmin, Daejeon 34122 (KR); LEE, Bomjin, Daejeon 34122 (KR); YOON, Du Seong, Daejeon 34122 (KR)
(74) Representative: Plasseraud IP
(86) International application number: PCT/KR2022/018432
(87) International publication number: WO 2023/106689

(56) References cited:
- CN-A- 112 816 895
- CN-A- 112 946 489
- KR-A- 20110 124 204
- KR-A- 20180 028 467
- KR-B1- 102 082 291
- US-A1- 2004 091 759
- US-A1- 2014 229 130
- MAHYAR J KOSHKOUEI ET AL: "Evaluation of an in situ QAM-based Power Line Communication system for lithium-ion batteries", IET ELECTRICAL SYSTEMS IN TRANSPORTATION, THE INSTITUTION OF ENGINEERING AND TECHNOLOGY, MICHAEL FARADAY HOUSE, SIX HILLS WAY, STEVENAGE, HERTS. SG1 2AY, UK, vol. 12, no. 1, 25 June 2021 (2021-06-25), pages 15 - 25, XP006115825, ISSN: 2042-9738, DOI: 10.1049/ELS2.12033
- KIM SEON HYEOG ET AL: "Harmonic Based Diagnostics for Aging Lithium-Ion Battery", 2019 IEEE 28TH INTERNATIONAL SYMPOSIUM ON INDUSTRIAL ELECTRONICS (ISIE), IEEE, 12 June 2019 (2019-06-12), pages 1971 - 1976, XP033585931, DOI: 10.1109/ISIE.2019.8781285

## Description

### [Technical Field]

### CROSS-REFERENCE TO RELATED APPLICATION

This application claims priority to and the benefit of Korean Patent Application No. 10-2021-0174607 filed in the Korean Intellectual Property Office on December 8, 2021, the entire contents of which are incorporated herein by reference.

The present invention relates to a method and an apparatus for diagnosing a battery cell.

### [Background Art]

An electric vehicle or hybrid vehicle is a vehicle that generally obtains power by driving a motor by using a battery as a power source, and research is being actively conducted in that the electric vehicle is an alternative capable of solving the pollution and energy problems of internal combustion vehicles. In addition, rechargeable batteries are used in various external devices other than electric vehicles.

Among batteries, in the case of a lithium battery which uses lithium ions in a redox reaction, lithium may be precipitated on the electrode depending on the usage environment of charging and discharging. Since lithium precipitation is one of the direct causes of battery ignition problems, a diagnosis method for detecting lithium precipitation is required. In particular, since it is difficult to detect lithium precipitation after manufacturing and selling batteries, a diagnosis method for detecting lithium precipitation during a battery production process is required. The document US 2014/229130 is known, but fails to cure the above mentioned issues.

### [Disclosure]

### [Technical Problem]

Certain example embodiments of the present invention may provide a method and an apparatus for diagnosing a battery cell capable of detecting lithium precipitation in an activation process.

### [Technical Solution]

An example embodiment of the present invention may provide a method of diagnosing a battery cell according to claim 1.

Another example embodiment of the present invention may provide an apparatus for diagnosing a battery cell according to claim 6.

In example embodiments, the diagnosing of the battery cell may include diagnosing the battery cell as a defective cell when the slope is equal to or less than a threshold value.

In example embodiments, the threshold value may be -8.2.

In example embodiments, the threshold value may be -8.

In example embodiments, the predetermined frequency may be equal to or less than 25 Hz.

In example embodiments, the predetermined frequency may be equal to or greater than 1 Hz and equal to or less than 25 Hz.

### [Advantageous Effects]

According to the example embodiment, it is possible to diagnose a defective cell in which lithium precipitation has occurred based on a reactance slope.

### [Description of the Drawings]

FIG. 1 is a diagram illustrating an example of a battery diagnosis apparatus according to an example embodiment of the present invention.
FIGS. 2, 3, 4, 5, 6, 7, 8, 9, 10, 11, 12, 13, 14, 15, 16, 17, 18, and 19 are respectively diagrams illustrating results of analyzing voltage and reactance of a battery cell measured in a charging section of an activation process while changing a frequency of an activation waveform.
FIG. 20 is a flowchart illustrating an example of a diagnosis method of the battery diagnosis apparatus according to an example embodiment of the present invention.

### [Mode for Invention]

In the following detailed description, only certain example embodiments of the present invention have been illustrated and described, simply by way of illustration. As those skilled in the art would realize, the described example embodiments may be modified in various different ways, all without departing from the spirit or scope of the present invention. Accordingly, the drawings and description are to be regarded as illustrative in nature and not restrictive. Like reference numerals designate like elements throughout the specification.

It should be understood that when one constituent element is referred to as being "coupled to" or "connected to" another constituent element, one constituent element can be directly coupled to or connected to the other constituent element, but intervening elements may also be present. By contrast, when one constituent element is referred to as being "directly coupled to" or "directly connected to" another constituent element, it should be understood that there are no intervening elements.

Expressions written in the singular in the following description may be interpreted in the singular or plural unless explicit expressions, such as "one" or "single", are used.

In the flowchart described with reference to the drawing, the order of operations may be changed, several operations may be merged, some operations may be divided, and specific operations may not be performed.

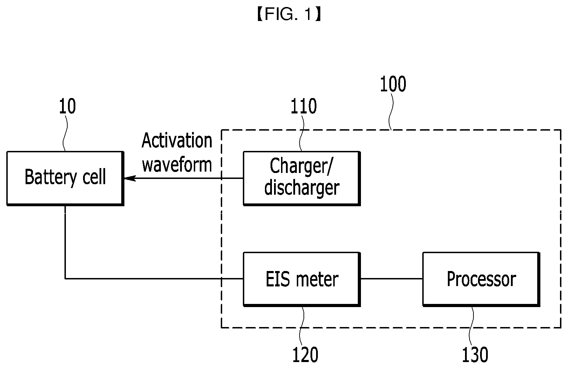

FIG. 1 is a diagram illustrating an example of a battery diagnosis apparatus according to an example embodiment of the present invention.

A battery diagnosis apparatus 100 is connected to battery cells 10 and diagnoses defective cells in which lithium precipitation occurs among the battery cells 10. In some example embodiments, the battery diagnosis apparatus 100 may be connected to the plurality of battery cells 10 to diagnose the plurality of battery cells 10. In some example embodiments, the battery cell 10 may be, for example, a lithium battery, such as a lithium ion battery or a lithium ion polymer battery.

The battery diagnosis apparatus 100 includes a charger/discharger 110, an electrochemical impedance spectroscopy (EIS) meter 120, and a processor 130. In some example embodiments, the processor 130 may be provided as a computing device.

In some example embodiments, the battery cell 10 may be manufactured by injecting an electrolyte into an electrode assembly including a negative electrode, a positive electrode, and a separator. Such a battery cell 10 may function as a battery by activation through charging and discharging, and this process is referred to as an activation process. The charger/discharger 110 may charge or discharge the battery cell 10 by applying an activation waveform to the battery cell 10 in the activation process. The activation waveform may be an AC potential having a predetermined frequency. In some example embodiments, the charger/discharger 110 may apply an activation waveform to the positive electrode terminal of the battery cell 10 in the state where a negative electrode terminal of the battery cell 10 is connected to a ground terminal. In some example embodiments, the charger/discharger 110 includes a plurality of channels to which the plurality of battery cells 10 is respectively connected, and may apply an activation waveform to each of the plurality of channels to charge or discharge the plurality of battery cells 10.

The EIS meter 120 performs EIS measurement on the battery cell 10 while the battery cell 10 is being charged or discharged. In some example embodiments, the EIS meter 120 may perform in-situ EIS measurements. The EIS meter 120 measures the response of the battery cell 10 while applying the activation waveform, and measures an imaginary component of impedance of the battery cell 10, that is, reactance based on the activation waveform and the response of the battery cell 10. In some example embodiments, the EIS meter 120 may measure an AC current response (that is, output current) of the battery cell 10 while applying the activation waveform (AC potential), and measure reactance of the battery cell 10 based on the AC potential and the output current. In some example embodiments, the EIS meter 120 may measure the reactance of the battery cell 10 by determining the phase shift and amplitude change of the output current based on the AC current response. Also, the EIS meter 120 may measure the voltage (that is, charging voltage) of the battery cell 10 in the charging section of the battery cell 10 while applying the activation waveform.

The processor 130 calculates a slope (change) of the reactance in a voltage section of a predetermined range based on the measurement result of the EIS meter 120, and diagnoses whether the battery cell 10 is a defective cell or a normal cell based on the slope of the reactance. In some example embodiments, the processor 130 may diagnose whether the battery cell 10 is a defective cell or a normal cell based on the slope of the reactance of the battery cell 10 according to the voltage of the battery cell 10 in a voltage section of a predetermined range among the voltages of the battery cell 10 in the charging section. In some example embodiments, when the reactance slope of the battery cell 10 according to the increase in voltage of the battery cell 10 is equal to or less than a threshold value in the voltage section of the predetermined range, the processor 130 may diagnose the corresponding battery cell 10 as a defective cell.

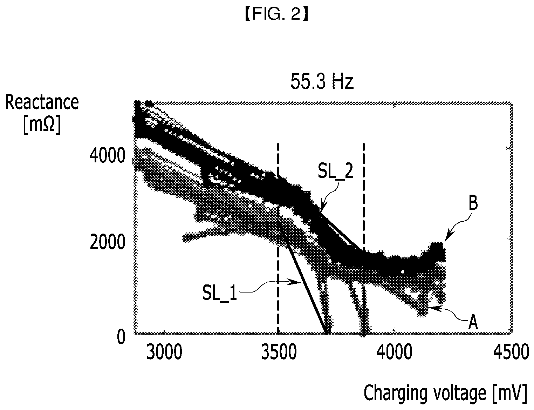

Next, a predetermined frequency and a voltage section of a predetermined range used in the battery diagnosis apparatus according to the example embodiment of the present invention will be described with reference to FIGS. 2 to 19.

FIGS. 2, 3, 4, 5, 6, 7, 8, 9, 10, 11, 12, 13, 14, 15, 16, 17, 18, and 19 are respectively diagrams illustrating results of analyzing voltage and reactance of a battery cell measured in a charging section of an activation process while changing a frequency of an activation waveform. In FIGS. 2 to 19, the horizontal axis represents voltage [mV] and the vertical axis represents reactance [mΩ].

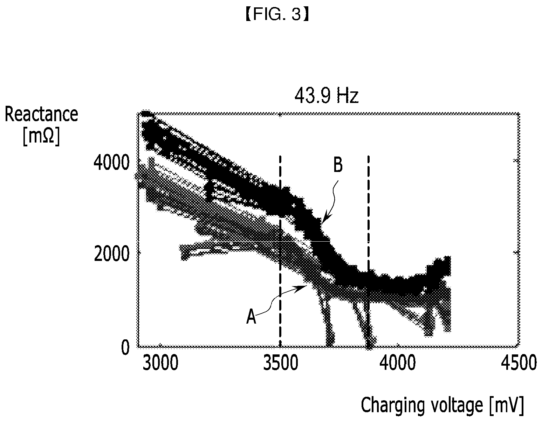

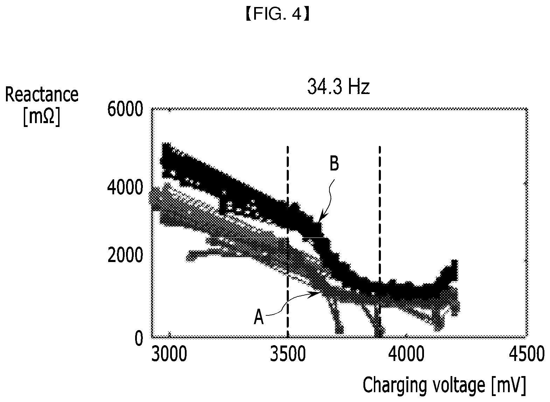

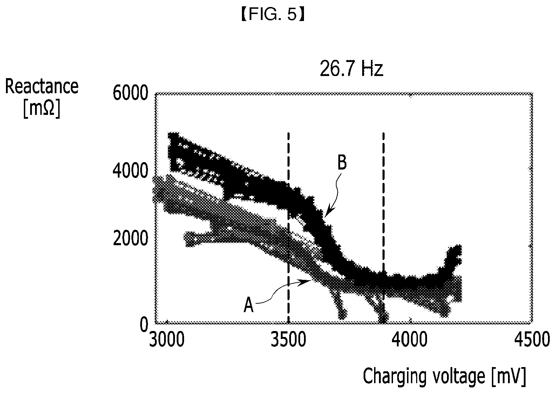

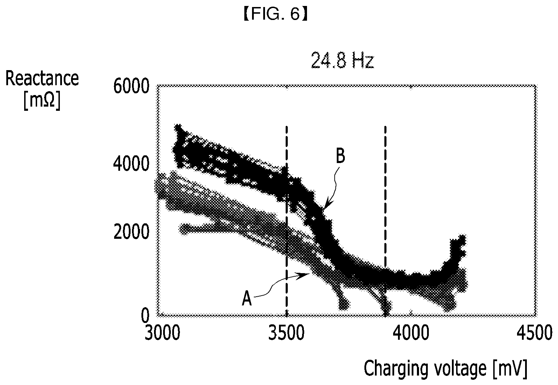

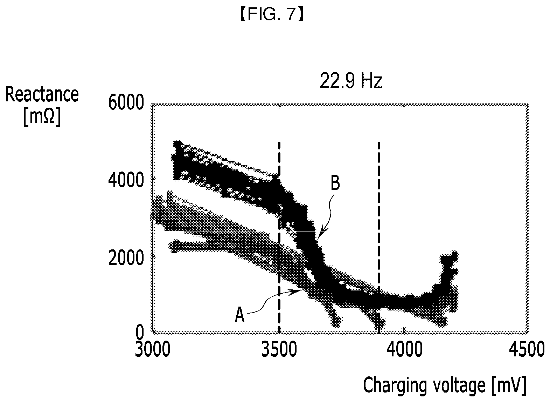

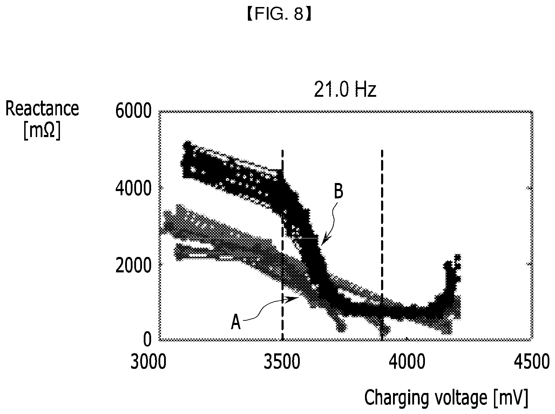

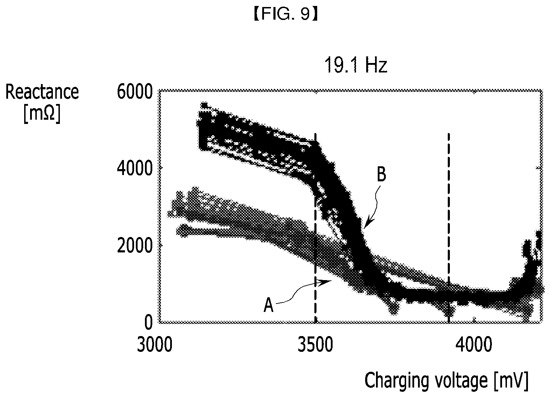

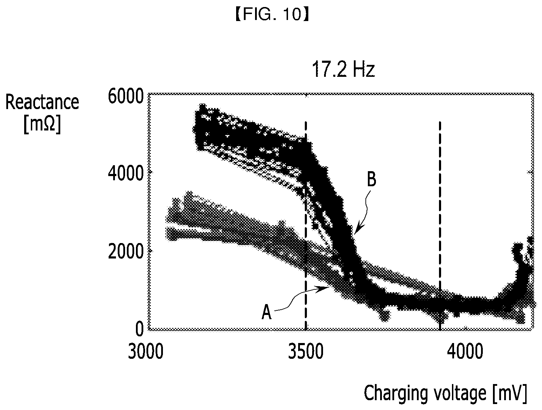

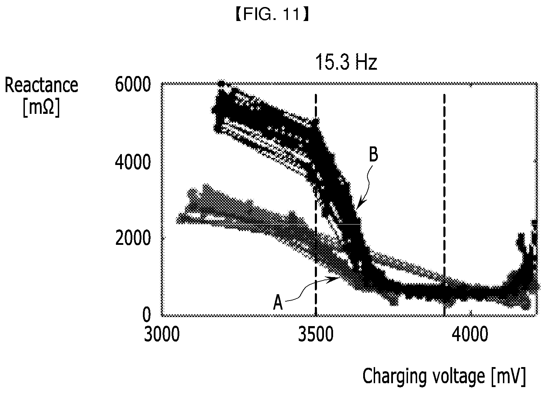

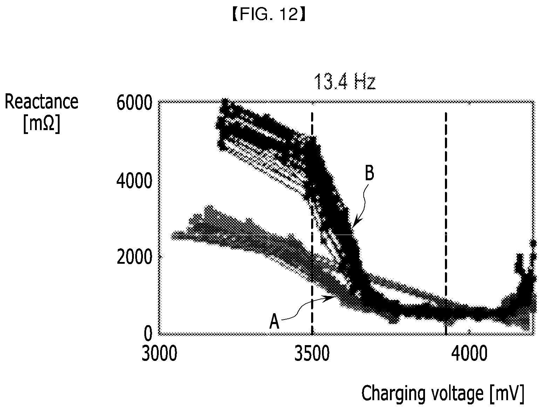

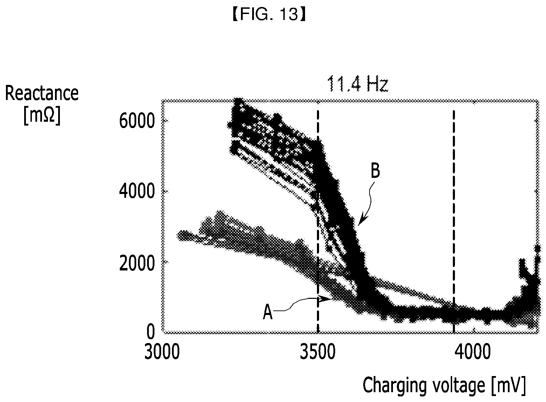

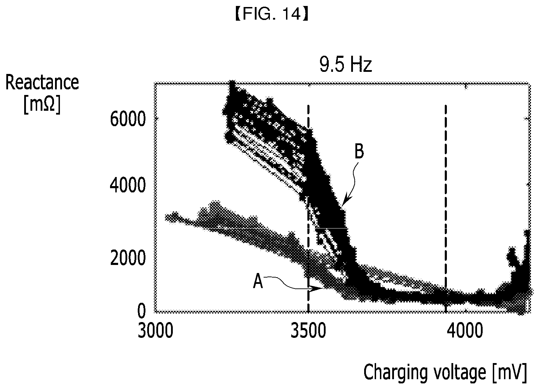

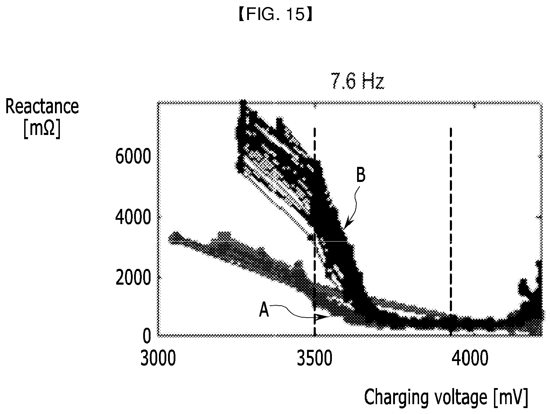

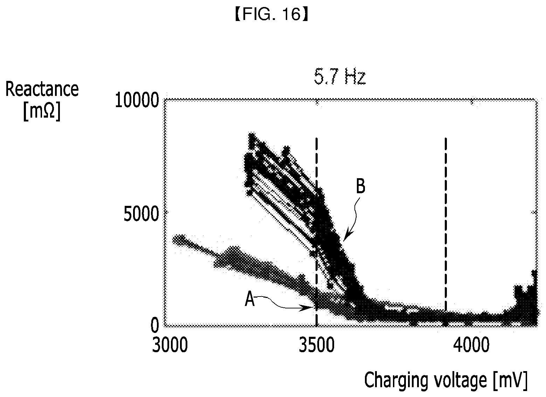

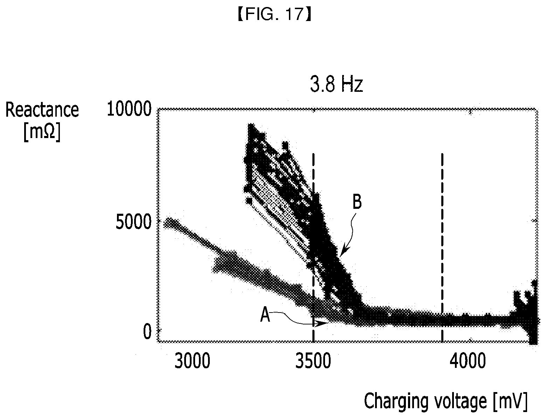

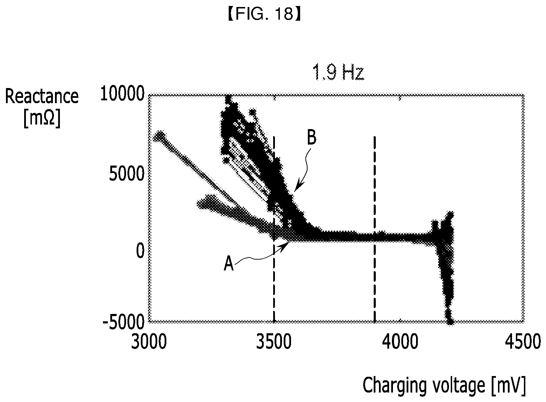

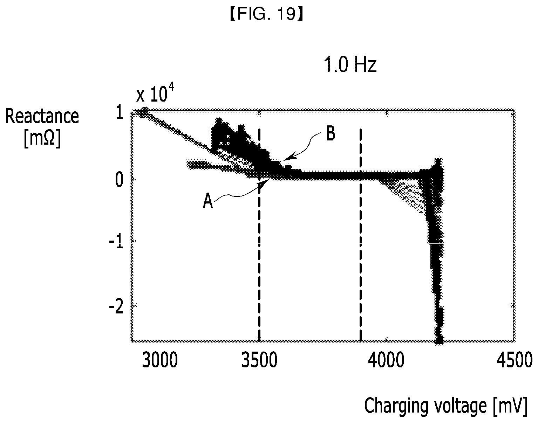

FIG. 2 illustrates a case where the frequency is 55.3 Hz, FIG. 3 illustrates a case where the frequency is 43.9 Hz, FIG. 4 illustrates a case where the frequency is 34.3 Hz, FIG. 5 illustrates a case where the frequency is 26.7 Hz, FIG. 6 illustrates a case where the frequency is 24.8 Hz, FIG. 7 illustrates a case where the frequency is 22.9 Hz, FIG. 8 illustrates a case where the frequency is 21.0 Hz, FIG. 9 illustrates a case where the frequency is 19.1 Hz, FIG. 10 illustrates a case where the frequency is 17.2 Hz, FIG. 11 illustrates a case where the frequency is 15.3 Hz, FIG. 12 illustrates a case where the frequency is 13.4 Hz, FIG. 13 illustrates a case where the frequency is 11.4 Hz, FIG. 14 illustrates a case where the frequency is 9.5 Hz, FIG. 15 illustrates a case where the frequency is 7.6 Hz, FIG. 16 illustrates a case where the frequency is 5.7 Hz, FIG. 17 illustrates a case where the frequency is 3.8 Hz, FIG. 18 illustrates a case where the frequency is 1.9 Hz, and FIG. 19 illustrates a case where the frequency is 1.0 Hz.

In each of FIGS. 2 to 19, a first group A is a group of reactance graphs for each of a plurality of normal cells, and a second group B is a group of reactance graphs for each of a plurality of defective cells. In each of FIGS. 2 to 19, reactance graphs for each of a plurality of normal cells and a plurality of defective cells overlap each other in some sections. That is, graphs may be difficult to be distinguished from each other in some sections. However, the first group A may be distinguished by light gray and the second group B may be distinguished by black. Meanwhile, although the boundary between the first group A and the second group B may be unclear in some voltage sections, data required in the present invention are disclosed in Table 1 below.

According to the example embodiment, in the charging voltage section between 3.5V and 3.8V illustrated in FIGS. 2 to 19, a reactance slope for a predetermined battery cell 10 may be calculated based on a difference value between a first reactance value corresponding to 3.5V and a second reactance value corresponding to 3.8V. That is, even though the reactance value exhibits the form of the graph increasing or decreasing more than the first reactance value or the second reactance value in the charging voltage section between 3.5V and 3.8V, the reactance slope may be calculated based on the first reactance value and the second reactance value. However, the present invention is not limited thereto, and according to various example embodiments, a reactance slope may be calculated in the charging voltage section between 3.5V and 3.8V.

Referring to FIG. 2, 'SL_1' may be a reactance slope for a normal cell, and SL_2' may be a reactance slope for a defective cell. Also, the reactance slope SL_1 or SL_2 may be graphs corresponding to a maximum value among a plurality of reactance slopes corresponding to the first group A or the second group B. However, the present invention is not limited thereto, and the reactance slopes SL_1 or SL_2 may indicate a minimum value or an average value among a plurality of reactance slopes corresponding to the first group A or the second group B.

Referring to FIGS. 2 to 19, in the case of a defective cell, it can be seen that the reactance rapidly decreases as the charging voltage increases in the voltage section of a predetermined range. In particular, it can be seen that when an activation waveform having a predetermined frequency is used, the reactance slope of the defective cell according to the increase in the charging voltage is distinguished from the reactance slope of the normal cell.

As illustrated in FIGS. 2 to 19, it can be seen that the magnitude (absolute value) of the reactance slope in the section where the charging voltage is 3.5V or more and 3.8V or less is greater than the magnitude of the reactance slope in other charging voltage sections. In addition, as illustrated in FIGS. 6 to 19, it can be seen that when an activation waveform having a frequency of 1 Hz or more and 25 Hz or less is used, the magnitude of the reactance slope of the defective cell is significantly larger than that of the normal cell to a distinguishable extent.

On the other hand, as illustrated in FIGS. 2 to 5 and 19, it can be seen that when an activation waveform having a frequency higher than 25 Hz is used, it is difficult to compare the magnitude of the reactance slope of a defective cell with the magnitude of the reactance slope of a normal cell.

Specifically, when the reactance slope in the charging voltage section between 3.5V and 3.8V illustrated in FIGS. 2 to 19 is digitized, the result is given as represented in Table 1. As shown in Table 1, the information on the reactance slope of each normal cell and the reactance slope of a defective cell for each frequency may be stored in a memory (not illustrated) of the battery diagnosis apparatus (reference numeral 100 in FIG. 1).

Since the reactance slope of the battery cell may change depending on the state of the battery cell, Table 1 shows the maximum value, minimum value, and average value of the reactance slope. Specifically, Table 1 shows the maximum value, minimum value, and average value among the plurality of reactance slopes belonging to the first group A for each frequency of the activation waveform. Further, Table 1 shows the maximum value, minimum value, and average value among the plurality of reactance slopes belonging to the second group B for each frequency of the activation waveform. In this case, the first group A is a group of reactance graphs for each of a plurality of normal cells, and the second group B is a group of reactance graphs for each of a plurality of defective cells.

### Table

Referring to Table 1, when the frequency of the activation waveform is greater than 25 Hz, since the section of the reactance slope of the defective cell partially overlaps the section of the reactance slope of the normal cell, it may be difficult to distinguish the reactance slope of the defective cell from the normal cell. For example, when the frequency of the activation waveform is 55.3 Hz, the reactance slope of the defective cell has a value between -6.03 and -5.00, and the reactance slope of the normal cell has a value between -6.85 and -3.26. Accordingly, when a reactance slope of a certain battery cell is measured as - 6.00, it cannot be distinguished whether the corresponding battery cell is a normal cell or a defective cell. Similarly, when the frequency of the activation waveform is 26.7 Hz, the reactance slope of the defective cell has a value between -9.40 and -7.51, and the reactance slope of the normal cell has a value between -7.54 and -2.40. Accordingly, when a reactance slope of a certain battery cell is measured as -7.52, it cannot be distinguished whether the corresponding battery cell is a normal cell or a defective cell.

However, when the frequency of the activation waveform is equal to or less than 25 Hz, since the section of the reactance slope of the defective cell and the section of the reactance slope of the normal cell do not overlap, the reactance slope of a defective cell and the reactance slope of a normal cell may be distinguished. For example, when the frequency of the activation waveform is 24.8 Hz, the reactance slope of the defective cell has a value between -10.86 and -8.20, and the reactance slope of a normal cell has a value between -6.91 and -2.45, so when a reactance slope of a certain battery cell is measured as a value of -8.20 or less, the corresponding battery cell may be determined to be a defective cell. Similarly, if the frequency of the activation waveform is 1.0 Hz, 1.9 Hz, 3.6 Hz, 5.7 Hz, 7.6 Hz, 9.5 Hz, 11.4 Hz, 13.4 Hz, 15.3 Hz, 17.2 Hz, 19.1 Hz, 21 Hz, or 22.9 Hz, since the section of the reactance slope of the defective cell and the section of the reactance slope of the normal cell do not overlap, a normal cell and a defective cell may be distinguished by the reactance slope.

**(Table 1)**

| frequency[H z] | Defective cell (second group, B) | | | Normal cell (first group, A) | | |
|---|---|---|---|---|---|---|
| | Minimum | Maximum | average | Minimum | Maximum | average |
| 55.3 | -6.03 | -5.00 | -5.51 | -6.85 | -3.26 | -4.57 |
| 43.9 | -7.02 | -5.71 | -6.38 | -6.81 | -2.27 | -4.60 |
| 34.3 | -8.36 | -6.55 | -7.32 | -6.98 | -1.72 | -4.55 |
| 26.7 | -9.40 | -7.51 | -8.48 | -7.54 | -2.40 | -4.42 |
| 24.8 | -10.86 | -8.20 | -9.69 | -6.91 | -2.45 | -4.38 |
| 22.9 | -12.47 | -8.92 | -10.98 | -6.81 | -1.79 | -4.33 |
| 21.0 | -14.76 | -9.40 | -12.19 | -6.39 | -1.37 | -4.15 |
| 19.1 | -16.37 | -9.37 | -13.14 | -6.56 | -0.39 | -4.10 |
| 17.2 | -16.73 | -8.76 | -13.40 | -6.42 | -0.67 | -3.92 |
| 15.3 | -16.80 | -8.66 | -13.56 | -5.84 | 0.16 | -3.75 |
| 13.4 | -19.19 | -8.58 | -13.90 | -6.27 | -0.78 | -3.54 |
| 11.4 | -19.87 | -7.83 | -14.44 | -5.89 | -1.24 | -3.30 |
| 9.5 | -21.34 | -7.52 | -14.75 | -5.43 | 0.28 | -3.02 |
| 7.6 | -22.05 | -6.61 | -14.97 | -4.78 | 0.16 | -2.70 |
| 5.7 | -22.63 | -5.92 | -14.53 | -3.87 | -0.13 | -2.23 |
| 3.6 | -21.63 | -4.92 | -13.69 | -3.27 | 0.40 | -1.58 |
| 1.9 | -19.53 | -3.46 | -11.89 | -1.74 | 0.71 | -0.97 |
| 1.0 | -13.49 | -2.03 | -8.24 | -1.59 | 1.04 | -0.30 |

As described above, when the frequency of the activation waveform is 25 Hz or less, normal cells and defective cells may be distinguished by the reactance slope in the charging voltage section between 3.5V and 3.8V. In particular, as shown in Table 1, when the frequency of the activation waveform is 25 Hz or less, since the smallest value among the maximum values of the reactance slope in the charging voltage section between 3.5V and 3.8V is -8.2, in some example embodiments, a discharge cell having a reactance slope of - 8.2, that is, a threshold value, or less may be determined as a defective cell. By setting the smallest value among the maximum values of the reactance slope as the threshold value, it is possible to prevent a normal cell from being determined as a defective cell.

In some example embodiments, since the minimum value of the reactance slope of a normal cell at 24.8 Hz is -6.91, the threshold value may be set to -8 that is greater than -8.2 in consideration of measurement error.

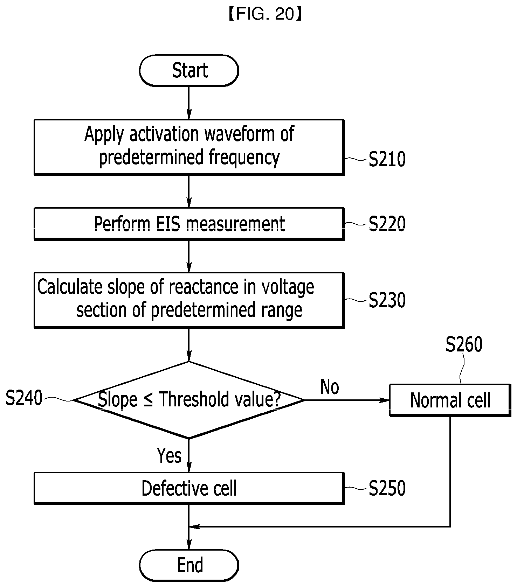

FIG. 20 is a flowchart illustrating an example of a diagnosis method of the battery diagnosis apparatus according to an example embodiment of the present invention.

Referring to FIG. 20, the battery diagnosis apparatus performs an activation process by applying an activation waveform having a predetermined frequency to a battery cell (S210). In some example embodiments, the predetermined frequency may be less than 25 Hz. In some example embodiments, the predetermined frequency may be equal to or greater than 1 Hz and equal to or less than 25 Hz. The battery diagnosis apparatus measures reactance and a charging voltage of the battery cell by performing EIS measurement on the battery cell in the charging section of the activation process (S220).

The battery diagnosis apparatus calculates a reactance slope of the battery cell according to the voltage of the battery cell in a charging voltage section of a predetermined range (S230). In some example embodiments, the charging voltage section of the predetermined range may be equal to or greater than -3.5V and equal to or less than -3.8V. The battery diagnosis apparatus compares the reactance slope with a threshold value (S240), and diagnoses the corresponding battery cell as a defective cell when the reactance slope is equal to or less than the threshold value (S250). In some example embodiments, the battery diagnosis apparatus may diagnose a corresponding battery cell as a defective cell in which lithium precipitation occurs. When the reactance slope is greater than the threshold value, the battery diagnosis apparatus diagnoses the corresponding battery cell as a normal cell (S260). In some example embodiments, the threshold value may be -8. In some example embodiments, the threshold value may be -8.2.

In some example embodiments, the battery diagnosis apparatus may obtain information on the reactance slopes of normal cells and the reactance slopes of defective cells corresponding to a predetermined frequency from a memory, and compare the calculated reactance slope may with the reactance slope obtained from the memory (S240). The battery diagnosis apparatus may diagnose the battery cell as a defective cell when the calculated reactance slope is included in the reactance slope of the defective cell (S250). The battery diagnosis apparatus may diagnose the battery cell as a normal cell when the calculated reactance slope is included in the reactance slope of the normal cell (S260).

According to the example embodiment described above, it is possible to diagnose a defective cell in which lithium precipitation has occurred based on a reactance slope.

In some example embodiments, a computing device (or processor) may perform operations on a computer program for executing the diagnostic method described above. The computer program for executing the diagnostic method may be loaded into memory. The computer program may include instructions that cause the computing device to perform the diagnosis method when loaded into memory. In some example embodiments, the computer program may cause the computing device to execute an operation of calculating a reactance slope of the battery cell in a voltage section of a predetermined range and an operation of diagnosing the battery cell based on the slope based on the EIS measurement performed in the charging section of the activation process for applying an activation waveform having a predetermined frequency to the battery cell.

Although an example embodiment of the present invention has been described in detail, the scope of the present invention is not limited by the example embodiment, but is defined by the following claims.

## Claims

1. A method of diagnosing a battery cell, the method comprising:
applying an activation waveform having a predetermined frequency to the battery cell in an activation process;
performing an electrochemical impedance spectroscopy, i.e. EIS, measurement in a charging section of the activation process;
based on the EIS measurement, calculating a slope of a reactance of the battery cell in a voltage section of a predetermined range, said slope of the reactance of the battery cell being calculated as a ratio between a difference of reactances obtained for different voltages over the differences of these voltages; and
diagnosing the battery cell based on the slope,
wherein the predetermined frequency is equal to or less than 25 Hz, and
wherein the voltage section includes a section between 3.5V and 3.8V.

2. The method of claim 1, wherein the diagnosing of the battery cell includes diagnosing the battery cell as a defective cell when the slope is equal to or less than a threshold value.

3. The method of claim 2, wherein the threshold value is -8.2.

4. The method of claim 2, wherein the threshold value is -8.

5. The method of claim 1, wherein the predetermined frequency is equal to or greater than 1 Hz and is equal to or lower than 25 Hz.

6. An apparatus for diagnosing a battery cell, the apparatus comprising:
a charger/discharger configured to apply an activation waveform having a predetermined frequency to the battery cell in an activation process;
an electrochemical impedance spectroscopy i.e. EIS, meter configured to perform an EIS measurement in a charging section of the activation process; and
a processor configured to calculate a slope of a reactance of the battery cell in a voltage section of a predetermined range based on the EIS measurement, said slope of the reactance of the battery cell being calculated as a ratio between a difference of reactances obtained for different voltages over the differences of these voltages, and diagnose the battery cell based on the slope,
wherein the predetermined frequency is equal to or less than 25 Hz, and
wherein the voltage section includes a section between 3.5V and 3.8V.

7. The apparatus of claim 6, wherein the processor diagnoses the battery cell as a defective cell when the slope is equal to or less than a threshold value.

8. The apparatus of claim 7, wherein the threshold value is -8.2.

9. The apparatus of claim 7, wherein the threshold value is -8.

10. The apparatus of claim 6, wherein the predetermined frequency is equal to or greater than 1 Hz and is equal to or lower than 25 Hz.

11. The apparatus of claim 6, further comprising:
a memory configured to store information on a reactance slope of a normal cell and a reactance slope of a defective cell for each frequency,
wherein the processor:
obtains information on the reactance slope of the normal cell and the reactance slope of the defective cell corresponding to the predetermined frequency from the memory,
diagnoses the battery cell as a normal cell when the reactance slope in the voltage section of the predetermined range is included in the reactance slope of the normal cell, and
diagnoses the battery cell as a defective cell when the reactance slope in the voltage section of the predetermined range is included in the reactance slope of the defective cell.

## Patentansprüche

1. Verfahren zum Diagnostizieren einer Batteriezelle, das Verfahren umfassend:
Anlegen einer Aktivierungswellenform, welche eine vorbestimmte Frequenz aufweist, an der Batteriezelle in einem Aktivierungsprozess;
Durchführen einer elektrochemischen Impedanz-Spektroskopie-, d.h. EIS,-Messung in einem Ladeabschnitt des Aktivierungsprozesses;
auf Grundlage der EIS-Messung, Berechnen einer Steigung einer Reaktanz der Batteriezelle in einem Spannungsabschnitt eines vorbestimmten Bereichs, wobei die Steigung der Reaktanz der Batteriezelle als ein Verhältnis zwischen einem Unterschied von Reaktanzen, welche für unterschiedliche Spannungen erhalten werden, über den Unterschieden dieser Spannungen berechnet wird; und
Diagnostizieren der Batteriezelle auf Grundlage der Steigung,
wobei die vorbestimmte Frequenz gleich wie oder geringer als 25 Hz ist, und
wobei der Spannungsabschnitt einen Abschnitt zwischen 3,5 V und 3,8 V umfasst.

2. Verfahren nach Anspruch 1, wobei das Diagnostizieren der Batteriezelle ein Diagnostizieren der Batteriezelle als eine beschädigte Zelle umfasst, wenn die Steigung gleich wie oder geringer als ein Schwellenwert ist.

3. Verfahren nach Anspruch 2, wobei der Schwellenwert -8,2 ist.

4. Verfahren nach Anspruch 2, wobei der Schwellenwert -8 ist.

5. Verfahren nach Anspruch 1, wobei die vorbestimmte Frequenz gleich wie oder größer als 1 Hz ist und gleich wie oder niedriger als 25 Hz ist.

6. Vorrichtung zum Diagnostizieren einer Batteriezelle, die Vorrichtung umfassend:
eine Lade-/Entladeeinheit, welche dazu eingerichtet ist, eine Aktivierungswellenform, welche eine vorbestimmte Frequenz aufweist, an der Batteriezelle in einem Aktivierungsprozess anzulegen;
eine elektrochemische Impedanz-Spektroskopie-, d.h. EIS,-Messeinheit, welche dazu eingerichtet ist, eine EIS-Messung in einem Ladeabschnitt des Aktivierungsprozesses durchzuführen; und
einen Prozessor, welcher dazu eingerichtet ist, eine Steigung einer Reaktanz der Batteriezelle in einem Spannungsabschnitt eines vorbestimmten Bereichs auf Grundlage der EIS-Messung zu berechnen, wobei die Steigung der Reaktanz der Batteriezelle als ein Verhältnis zwischen einem Unterschied von Reaktanzen, welche für unterschiedliche Spannungen erhalten sind, über den Unterschieden dieser Spannungen berechnet ist; und die Batteriezelle auf Grundlage der Steigung zu diagnostizieren,
wobei die vorbestimmte Frequenz gleich wie oder geringer als 25 Hz ist, und
wobei der Spannungsabschnitt einen Abschnitt zwischen 3,5 V und 3,8 V umfasst.

7. Vorrichtung nach Anspruch 6, wobei der Prozessor die Batteriezelle als eine beschädigte Zelle diagnostiziert, wenn die Steigung gleich wie oder geringer als ein Schwellenwert ist.

8. Vorrichtung nach Anspruch 7, wobei der Schwellenwert -8,2 ist.

9. Vorrichtung nach Anspruch 7, wobei der Schwellenwert -8 ist.

10. Vorrichtung nach Anspruch 6, wobei die vorbestimmte Frequenz gleich wie oder größer als 1 Hz ist und gleich wie oder niedriger als 25 Hz ist.

11. Vorrichtung nach Anspruch 6, ferner umfassend:
einen Speicher, welcher dazu eingerichtet ist, Informationen zu einer Reaktanzsteigung einer normalen Zelle und einer Reaktanzsteigung einer beschädigten Zelle für jede Frequenz zu speichern,
wobei der Prozessor:
Informationen zu der Reaktanzsteigung der normalen Zelle und der Reaktanzsteigung der beschädigten Zelle entsprechend der vorbestimmten Frequenz aus dem Speicher erhält,
die Batteriezelle als die normale Zelle diagnostiziert, wenn die Reaktanzsteigung in dem Spannungsabschnitt des vorbestimmten Bereichs in der Reaktanzsteigung der normalen Zelle umfasst ist, und
die Batteriezelle als die beschädigte Zelle diagnostiziert, wenn die Reaktanzsteigung in dem Spannungsabschnitt des vorbestimmten Bereichs in der Reaktanzsteigung der beschädigten Zelle umfasst ist.

## Revendications

1. Procédé de diagnostic d'un élément de batterie, le procédé comprenant :
l'application d'une forme d'onde d'activation ayant une fréquence prédéterminée à l'élément de batterie dans un processus d'activation ;
la réalisation d'une mesure par spectroscopie d'impédance électrochimique, c'est-à-dire une EIS, dans une section de charge du processus d'activation ;
sur la base de la mesure par EIS, le calcul d'une pente d'une réactance de l'élément de batterie dans une section de tension d'une plage prédéterminée, ladite pente de la réactance de l'élément de batterie étant calculée sous la forme d'un rapport entre une différence de réactances obtenues pour différentes tensions et les différences de ces tensions ; et
le diagnostic de l'élément de batterie sur la base de la pente,
dans lequel la fréquence prédéterminée est inférieure ou égale à 25 Hz, et
dans lequel la section de tension comprend une section entre 3,5 V et 3,8 V.

2. Procédé selon la revendication 1, dans lequel le diagnostic de l'élément de batterie comprend le diagnostic du fait que l'élément de batterie est un élément défectueux lorsque la pente est inférieure ou égale à une valeur seuil.

3. Procédé selon la revendication 2, dans lequel la valeur seuil est -8,2.

4. Procédé selon la revendication 2, dans lequel la valeur seuil est -8.

5. Procédé selon la revendication 1, dans lequel la fréquence prédéterminée est supérieure ou égale à 1 Hz et est inférieure ou égale à 25 Hz.

6. Appareil de diagnostic d'un élément de batterie, l'appareil comprenant :
un dispositif de charge/décharge configuré pour appliquer une forme d'onde d'activation ayant une fréquence prédéterminée à l'élément de batterie dans un processus d'activation ;
un dispositif de mesure par spectroscopie d'impédance électrochimique, c'est-à-dire une EIS, configuré pour effectuer une mesure par EIS dans une section de charge du processus d'activation ; et
un processeur configuré pour calculer une pente d'une réactance de l'élément de batterie dans une section de tension d'une plage prédéterminée sur la base de la mesure par EIS, ladite pente de la réactance de l'élément de batterie étant calculée sous la forme d'un rapport entre une différence de réactances obtenues pour différentes tensions et les différences de ces tensions, et diagnostiquer l'élément de batterie sur la base de la pente,
dans lequel la fréquence prédéterminée est inférieure ou égale à 25 Hz, et
dans lequel la section de tension comprend une section entre 3,5 V et 3,8 V.

7. Appareil selon la revendication 6, dans lequel le processeur diagnostique que l'élément de batterie est un élément défectueux lorsque la pente est inférieure ou égale à une valeur seuil.

8. Appareil selon la revendication 7, dans lequel la valeur seuil est -8,2.

9. Appareil selon la revendication 7, dans lequel la valeur seuil est -8.

10. Appareil selon la revendication 6, dans lequel la fréquence prédéterminée est supérieure ou égale à 1 Hz et est inférieure ou égale à 25 Hz.

11. Appareil selon la revendication 6, comprenant en outre :
une mémoire configurée pour stocker des informations sur une pente de réactance d'un élément normal et une pente de réactance d'un élément défectueux pour chaque fréquence,
dans lequel le processeur :
obtient des informations sur la pente de réactance de l'élément normal et la pente de réactance de l'élément défectueux correspondant à la fréquence prédéterminée à partir de la mémoire,
diagnostique que l'élément de batterie est un élément normal lorsque la pente de réactance dans la section de tension de la plage prédéterminée est incluse dans la pente de réactance de l'élément normal, et
diagnostique que l'élément de batterie est un élément défectueux lorsque la pente de réactance dans la section de tension de la plage prédéterminée est incluse dans la pente de réactance de l'élément défectueux.
